# FASCICULE DE BREVET EUROPEEN

(11) **EP 2 833 460 B1**
(45) Date de publication et mention de la délivrance du brevet: **25.05.2016**
(21) Numéro de dépôt: 14178837.2
(22) Date de dépôt: 28.07.2014
(51) Int. Cl.: H01M 2/02, H01M 2/04, H01M 2/08, H01M 10/0585, H01M 10/04, H01M 10/052, H01M 4/38, C23C 16/06, B32B 37/12

(54) **Microbatterie au lithium protégée par un capot**
Lithium-Mikrobatterie mit Schutzhülle
Lithium microbattery protected by a cover

(30) Priorité: 30.07.2013 FR 1301831
(43) Date de publication de la demande: 04.02.2015
(73) Titulaire: Commissariat à l'Energie Atomique et aux Energies Alternatives, 75015 Paris (FR)
(72) Inventeur: Bedjaoui, Messaoud, 38340 Voreppe (FR); Desre, Hermance, 38000 Grenoble (FR); Ennajdaoui, Aboubakr, 63100 Clermont-Ferrand (FR); Poulet, Sylvain, 38110 Saint Victor de Cessieu (FR)
(74) Mandataire: Talbot, Alexandre

(56) Documents cités:
- EP-A1- 2 262 036
- EP-A1- 2 432 065
- WO-A1-01/89006
- US-A1- 2010 291 431
- US-A1- 2013 164 607

## Description

### Domaine technique de l'invention

L'invention est relative à une microbatterie au lithium, et plus particulièrement au système d'encapsulation qui protège les couches actives de l'environnement extérieur.

### État de la technique

Une microbatterie au lithium comporte classiquement deux électrodes (positive et négative) séparées par un électrolyte. L'électrode positive est formée dans un matériau ayant une bonne conductivité ionique, par exemple l'oxysulfure de titane (TiOS). L'électrolyte est un isolant électrique ayant une forte conductivité ionique, tel que l'oxynitrure de lithium et de phosphore (LiPON). Enfin, la nature de l'électrode négative varie en fonction de la technologie de la microbatterie.

Dans les microbatteries dites « lithium-ion », l'électrode négative est constituée d'un matériau lithié, c'est-à-dire un matériau dans lequel est inséré des ions lithium. Dans les microbatteries « lithium-métal », l'électrode négative est exclusivement formée de lithium.

Les matériaux contenant du lithium sont très sensibles à l'air, et en particulier à l'oxygène et l'humidité. Pour éviter qu'ils s'oxydent, ils doivent être recouverts d'une barrière de protection inerte et étanche. La maîtrise de l'encapsulation est un facteur primordial qui conditionne l'efficacité dans le temps des microbatteries.

La qualité d'un système d'encapsulation peut être évaluée selon trois critères :
- le niveau de barrière : les performances de la barrière de protection sont définies par le taux de perméation des espèces oxydantes. Pour les microbatteries au lithium, le niveau barrière recherché se situe généralement entre 10⁻⁴ et 10⁻⁵ g/m²/jour.
- la tenue mécanique : le système d'encapsulation doit être capable d'accommoder les variations volumiques de la microbatterie, lors des cycles de charge et de décharge. A défaut, l'expansion ou la contraction de la microbatterie peut entraîner des dommages mécaniques dans les électrodes, se traduisant par une diminution irréversible de la capacité électrique.
- la compatibilité physico-chimique : le système d'encapsulation doit être compatible chimiquement avec les matériaux contenant du lithium et sa réalisation ne doit pas endommager les couches actives.

Les solutions d'encapsulation d'une microbatterie au lithium peuvent être réparties en deux catégories : l'encapsulation en couches minces et l'encapsulation par élément rapporté.

Les solutions d'encapsulation par élément rapporté consistent à coller un capot, par exemple en verre ou en matériau polymère laminé, au-dessus des couches actives de la microbatterie. Ce type d'encapsulation satisfait aux trois critères précités, le niveau de barrière étant particulièrement élevé. En effet, compte tenu son épaisseur, le taux de perméation du capot vis-à-vis des espèces oxydantes est inférieur à celui d'un empilement de couches minces en polymère, métal et/ou céramique.

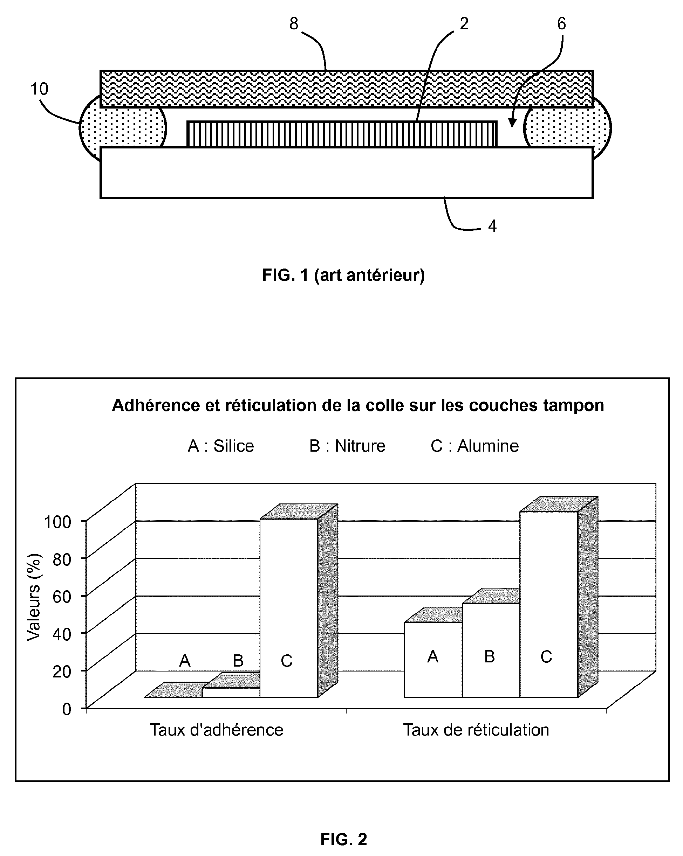

La figure 1 représente schématiquement une microbatterie au lithium munie d'un système d'encapsulation par élément rapporté, tel que décrit dans le document US2006/0216589.

La microbatterie comprend un empilement 2 de couches actives, formé sur un substrat 4. L'empilement 2 est contenu dans une cavité 6 délimitée par le substrat 4 et par un capot 8 faisant face au substrat. Un cordon de colle 10 en résine époxy solidarise le capot 8 au substrat 4, autour de l'empilement 2.

Dans cette configuration, le substrat 6 et le capot 8 forment les faces principales de la microbatterie, respectivement inférieure et supérieure. Comme ils sont étanches aux espèces oxydant le lithium, la protection surfacique de la microbatterie est totale. Par contre, pour assurer simultanément le maintien du capot 8 sur le substrat 4 et une protection des flancs de la microbatterie, le cordon de colle 10 occupe une vaste zone autour de l'empilement 2. Une surface importante du substrat est ainsi dédiée à la cavité 6 et au cordon de scellement 10, au détriment de la surface utile de la microbatterie.

US 2013/164607 décrit une microbatterie au lithium comprenant un empilement de couches actives contenant du lithium et un capot de protection couvrant l'empilement de couches actives, le capot de protection étant fixé à l'empilement de couches actives au moyen d'une couche de polymère et une couche tampon en alumine disposée entre l'empilement de couches actives et la couche de polymère ainsi qu'une autre couche polymère entre l'empilement et la couche d'alumine.

### Résumé de l'invention

On constate qu'il existe un besoin de prévoir une microbatterie au lithium à l'encombrement réduit, avec un dispositif d'encapsulation performant et compact.

On tend à satisfaire ce besoin en prévoyant une microbatterie au lithium comprenant un empilement de couches actives contenant du lithium et un capot de protection couvrant l'empilement de couches actives. Le capot de protection est fixé à l'empilement de couches actives au moyen d'une couche de colle.

Une structure tampon comprenant au moins une couche en alumine est disposée entre l'empilement de couches actives et la couche de colle. La structure tampon est en contact avec l'empilement de couches actives. Dans un mode de réalisation préférentiel, la couche d'alumine de la structure tampon est en contact avec la couche de colle.

Dans un mode de réalisation préférentiel, au moins la couche en alumine de la structure tampon couvre entièrement l'empilement de couches actives afin de protéger efficacement les flancs de la microbatterie.

L'empilement comporte avantageusement une électrode en lithium métallique en contact avec la structure tampon.

On prévoit également un procédé de fabrication d'une telle microbatterie. Le procédé comprend le dépôt d'une structure tampon comprenant au moins une couche en alumine sur un empilement de couches actives contenant du lithium, le dépôt d'une couche en matériau polymérisable sur la structure tampon, une étape consistant à couvrir l'empilement de couches actives et la couche en matériau polymérisable par un capot de protection et la réticulation du matériau polymérisable pour coller le capot à l'empilement de couches actives.

De préférence, la couche d'alumine est obtenue par dépôt de couches atomiques (ALD). Ainsi, le dépôt d'alumine sur l'empilement de couches actives est homogène et la couche obtenue est imperméable aux espèces chimiques qui pourraient oxyder les couches actives.

Le dépôt de couches atomiques est avantageusement réalisé à partir d'un premier précurseur contenant de l'aluminium et d'un deuxième précurseur contenant de l'eau.

Les premier et deuxième précurseurs sont notamment utilisés de façon successive, en commençant par le premier précurseur.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, est une représentation schématique d'une microbatterie au lithium selon l'art antérieur ;
- la figure 2 est un graphique montrant les taux de réticulation et d'adhérence d'une couche de colle déposée au-dessus d'une couche de lithium, avec une couche tampon en silice, nitrure de silicium ou alumine interposée entre la couche de colle et la couche de lithium ;
- la figure 3 représente un mode de réalisation préférentiel d'une microbatterie au lithium munie d'une structure tampon selon l'invention ;
- la figure 4 est un diagramme d'impédance de la microbatterie au lithium selon la figure 3, avant et après dépôt de la couche d'alumine ; et
- les figures 5 à 9 représentent des étapes d'un procédé de fabrication d'une microbatterie au lithium selon l'invention.

### Description d'un mode de réalisation préféré de l'invention

Afin de réduire l'encombrement du système d'encapsulation, une solution consisterait à coller le capot de protection directement sur l'empilement des couches actives de la microbatterie, plutôt qu'à sa périphérie. Les colles couramment utilisées pour le report du capot sont des matériaux polymérisables. Or, le lithium contenu dans les couches actives inhibe la polymérisation des colles. Cette solution n'est donc pas envisageable, à moins de prévoir une structure tampon adéquate qui bloquerait la diffusion du lithium vers le matériau polymérisable.

Après plusieurs essais, il a été découvert qu'une structure tampon comprenant au moins une couche en alumine remplissait parfaitement cette fonction.

On entend par structure tampon, une ou plusieurs couches de matériaux isolants aptes à bloquer la diffusion du lithium vers la couche polymérisable. Ces matériaux peuvent être choisis notamment parmi l'alumine, SiO₂, Si₃N₄, SiOₓC_{y}, SiOₓN_{y}, ou encore une combinaison de ces matériaux.

Par ailleurs, la structure tampon doit avoir des propriétés de surface permettant une bonne adhérence avec le matériau polymérisable pour obtenir une bonne fixation du capot.

Préférentiellement, la structure tampon comprend au moins une couche d'alumine destinée à être en contact avec ladite couche polymérisable.

Enfin, cette structure tampon doit également avoir des caractéristiques mécaniques permettant d'absorber des variations de volume de l'empilement et permettre de former une barrière aux espèces susceptibles de dégrader le lithium (H₂O, O₂, N₂).

Pour ces essais, on a considéré plusieurs échantillons comprenant chacun une structure comprenant au moins une couche tampon. Chaque échantillon comporte une couche de lithium, recouverte de la structure tampon puis d'une couche de colle. Seule la nature de la couche tampon varie entre les échantillons. Les couches tampon à l'étude sont en silice (SiO₂), en nitrure de silicium (Si₃N₄) et en alumine (Al₂O₃), et mesurent entre 30 nm à 300 nm d'épaisseur environ. La colle est une résine d'époxyde couramment utilisé dans les solutions d'encapsulation par report de capot. Elle est commercialisée par la société Epoxy Technology sous la référence OG146-178.

La figure 2 représente, à titre de comparaison, les taux d'adhérence et de réticulation de la couche de colle disposée sur les différentes couches tampon susmentionnées.

Les résultats montrent que le taux de réticulation de la colle OG146-178 est bien meilleur lorsque celle-ci est déposée sur une couche tampon en alumine, plutôt qu'une couche tampon en oxyde ou nitrure de silicium. En effet, le taux de réticulation de la colle sur la couche d'alumine avoisine 99 %, tandis que sur les couches en SiO₂ et Si₃N₄, il atteint respectivement 40 % et 50 %. Par ailleurs, la couche de colle OG146-178 adhère parfaitement à la couche tampon en alumine (taux d'adhérence d'environ 95 %), à la différence de celle déposée sur les couches en silice et nitrure de silicium (0 % et 5 % respectivement).

Des résultats similaires ont été obtenus avec de nombreuses variantes de couches tampon, notamment en oxycarbure de silicium (SiOₓC_{y}), en oxynitrure de silicium (SiOₓN_{y}), ou avec des systèmes multicouches (SiO₂/Si₃N₄ par exemple).

Une couche tampon en alumine permet donc la polymérisation complète de la colle, à la différence des couches tampon à base de silice et/ou de nitrure de silicium. Autrement dit, la couche en alumine est quasiment imperméable aux ions lithium, inhibiteurs de polymérisation.

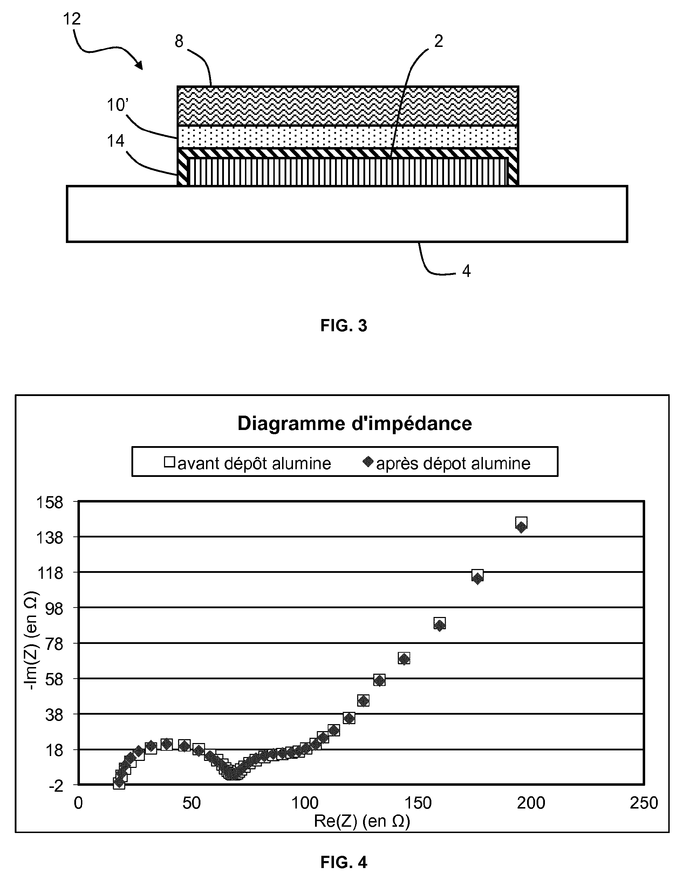

La figure 3 représente schématiquement une microbatterie au lithium dont l'encombrement est réduit grâce à l'utilisation d'une structure tampon comprenant au moins une couche en alumine.

La microbatterie comprend classiquement un empilement 2 de couches actives déposées sur un substrat 4. Les couches actives de la microbatterie désignent ici les électrodes négative et positive (anode et cathode) et l'électrolyte situé entre les deux électrodes.

L'électrode positive est formée d'une couche en matériau d'insertion du lithium, tel que l'oxysulfure de titane TiOS, le pentoxyde de vanadium V₂O₅ ou le disulfure de titane TiS₂. La couche d'électrolyte est, de préférence, constituée d'oxynitrure de lithium et de phosphore (LiPON). Enfin, l'anode est formée d'un matériau contenant du lithium, par exemple en lithium pur, i.e. sous forme métallique (batterie Li-métal), ou en un matériau d'insertion (NiO₂, SnO, Si, Ge, C...) lithié (batterie lithium-ion).

La microbatterie de la figure 3 comprend également un dispositif d'encapsulation 12 formé sur l'empilement 2. Le dispositif d'encapsulation 12 vise à protéger les couches actives de l'oxydation, et plus particulièrement l'électrode située en haut de l'empilement 2, à l'opposé du substrat 4.

L'électrode supérieure est en effet la couche active la plus exposée aux espèces oxydantes. C'est aussi celle qui, en général, contient le plus de lithium, à savoir l'anode. Cette configuration particulière des électrodes rend encore plus critique l'étape d'encapsulation.

Le dispositif d'encapsulation 12 comporte un capot de protection 8 et une couche de colle 10', en matériau polymère, pour fixer le capot à l'empilement 2 de couches actives 18, 20, 22. En outre, il comporte une structure tampon 14 comprenant au moins une couche d'alumine, interposée entre la couche de colle 10' et l'empilement 2.

Préférentiellement, la couche d'alumine de la structure tampon 14 est en contact avec la couche de colle 10'.

La structure tampon 14 peut comprendre deux couches d'alumine séparées par une couche additionnelle élaborée en un autre matériau.

Selon un mode de réalisation, la structure tampon 14 est formée par la couche en alumine.

La structure tampon 14 est en contact avec ledit empilement 2 de couches actives 18, 20, 22.

La structure tampon 14 est disposée en contact avec une ou plusieurs couches actives contenant du lithium. Elle joue le rôle de structure tampon entre la couche de colle 10' et ces couches actives, en bloquant la diffusion des ions lithium. Elle permet ainsi une réticulation complète de la couche de colle 10', et donc, la fixation du capot 8 sur l'empilement 2. Par ailleurs, la structure tampon 14 est inerte chimiquement vis-à-vis des constituants des couches actives, et du lithium en particulier.

L'épaisseur de la couche en alumine est avantageusement comprise entre 5 nm et 50 nm. En choisissant une épaisseur dans cette plage, on obtient un bon compromis entre l'encombrement du dispositif d'encapsulation et le blocage des ions lithium.

Le capot 8 couvre la face supérieure de l'empilement 2. Il assure donc, en coopération avec le substrat 4, la protection surfacique de la microbatterie. Le capot 8 peut être en verre, métal, céramique ou en polymère laminé. Son épaisseur est, de préférence, comprise entre 50 µm et 1000 µm.

La structure tampon 14 et la couche de colle 10' sont avantageusement disposées sur toute la face supérieure de l'empilement 2. Le capot de protection 8 est ainsi fixé solidement et durablement à l'empilement.

En plus de son rôle de colle, la couche 10' en matériau polymère absorbe les variations de volume de la microbatterie lors des cycles de charge et de décharge. Pendant ces variations volumiques, la couche d'alumine 14 est faiblement contrainte (< 100MPa). Elle peut subir de nombreux cycles de charge/décharge (plus de 500 cycles), sans observer de dégradation. Le matériau polymère est, de préférence, choisi parmi les éthers vinyliques et les époxydes. Comme cela sera décrit plus loin, l'épaisseur de la couche 10' peut varier entre 2 µm et 20 µm, selon la technique de dépôt envisagée.

Ainsi, le capot 8, associé à la couche de colle 10' et la structure tampon 14 en alumine, forme un système d'encapsulation performant, compact et robuste.

Pour vérifier les performances d'encapsulation, des études de vieillissement ont été réalisées sur des microbatteries munies d'un capot et d'une structure tampon comprenant au moins une couche en alumine. Ces microbatteries ont été stockées, pendant 5 mois, dans des contions semblables aux conditions d'utilisation des microbatteries. Elles ont été soumises à une atmosphère oxydante : de l'air à 25 °C chargé d'humidité. Des mesures de la capacité de décharge ont permis de calculer un taux de perméation d'environ 10⁻⁴ g/m²/j, soit le niveau de barrière recherché pour l'encapsulation des microbatteries au lithium.

La structure tampon 14 présente également l'avantage d'être électriquement isolante. Elle ne risque donc pas de créer de court-circuit entre les différentes couches électriquement actives de l'empilement.

A cet égard, on a cherché à savoir si l'utilisation d'une structure tampon comprenant au moins une couche d'alumine en contact avec les couches actives ne modifiait pas la signature électrique de la microbatterie.

La figure 4 représente le diagramme d'impédance électrique de la microbatterie, ou diagramme de Nyquist, avant et après formation de la couche d'alumine. On ne constate aucune modification du spectre d'impédance causée par la couche en alumine.

Dans le mode de réalisation préférentiel de la figure 3, au moins la couche d'alumine de la structure tampon 14 recouvre entièrement l'empilement 2 de couches actives, c'est-à-dire la face supérieure et les faces latérales de l'empilement. La couche d'alumine est capable de bloquer, en plus des ions lithium, les espèces oxydantes telles que l'oxygène et l'eau. La couche d'alumine assure alors une protection des flancs de la microbatterie, en plus de son rôle de tampon.

Dans les dispositifs de l'art antérieur, la protection latérale de la microbatterie est souvent négligée. Par exemple, dans le document US2006/0216589 (Fig.1), les flancs de la microbatterie ne sont pas suffisamment protégés, car la colle utilisée pour sceller le capot ne constitue pas une barrière avec le niveau requis pour l'encapsulation d'une microbatterie au lithium (10⁻⁴ g/m²/j).

Dans la microbatterie de la figure 3, la protection latérale est au contraire satisfaisante, car la couche d'alumine dispose d'un bon niveau de barrière, supérieure au niveau minium requis. Le niveau de barrière global du dispositif d'encapsulation 12 atteint alors une valeur de 5.10⁻⁵ g/m²/j.

Cette protection des flancs de la microbatterie est d'ailleurs d'autant plus avantageuse que la surface de la microbatterie est faible. En effet, la diffusion des espèces oxydantes au travers des flancs devient aussi importante que la diffusion par la face supérieure, pour des microbatteries de petite surface. Il est donc préférable de couvrir les faces latérales de l'empilement avec la couche d'alumine, dans le cas de microbatteries au lithium de faibles dimensions.

La couche d'alumine ayant de bonnes propriétés barrière, elle pourrait assurer seule la protection en face supérieure de la microbatterie. On préfère toutefois utiliser un capot, car la protection surfacique est dans ce cas totale. Le capot est en effet imperméable à l'oxygène et l'humidité, comme le substrat.

De préférence, l'électrode supérieure, située immédiatement sous la structure tampon 14 comprenant au moins une couche d'alumine, est formée exclusivement de lithium. On privilégie ainsi les microbatteries de la technologie Li-métal, car le capot de protection satisfait pleinement aux exigences d'encapsulation fortes de cette technologie. En effet, l'électrode supérieure en lithium métallique nécessite une encapsulation optimale, qui peut être obtenue par l'association d'un capot et d'une structure tampon 14. On peut alors profiter pleinement des avantages apportés par cette technologie : forte densité énergétique, tension nominale plus élevée et mise en oeuvre plus facile que la technologie Li-ion.

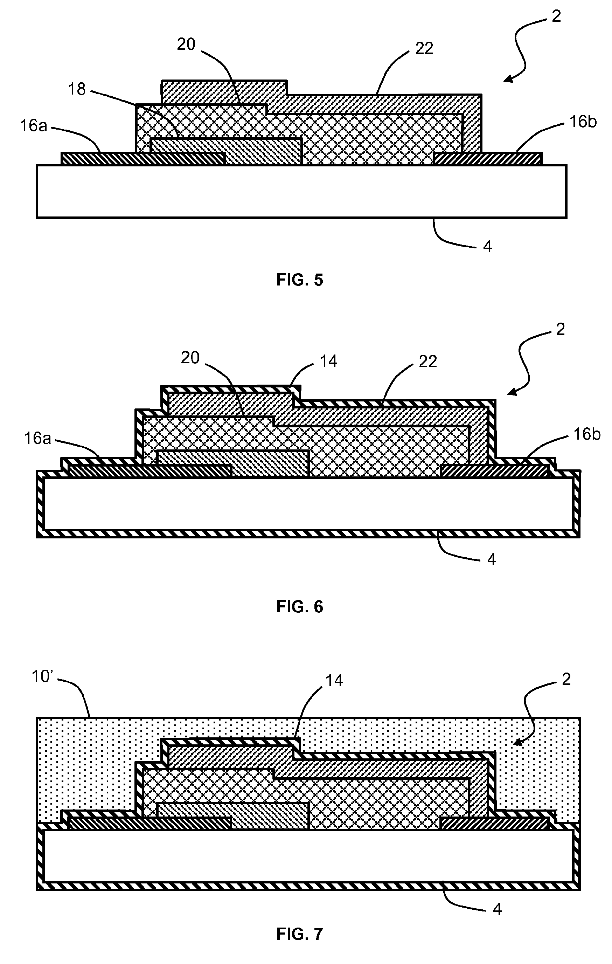

Les figures 5 à 9 représentent des étapes de fabrication d'une microbatterie au lithium munie d'un dispositif d'encapsulation 12 selon la figure 3. L'étape de la figure 5 correspond à la formation de l'empilement 2 de couches actives et les étapes des figures 6 à 9 correspondent à la formation et à la délimitation du dispositif d'encapsulation.

La figure 5 représente le substrat 4 de départ et des collecteurs de courant 16a et 16b formés sur une face du substrat 4. Le substrat 4, par exemple, en silicium, polymère ou verre, mesure entre 100 µm et 1000 µm d'épaisseur.

Les collecteurs de courant 16a et 16b sont en matériau électriquement conducteur, par exemple en titane, tungstène ou en or. Ces collecteurs sont déposés sous forme de couches minces (200 nm environ), par dépôt physique en phase vapeur (PVD, « Physical Vapor Deposition » en anglais) par exemple. Ils sont destinés à former les bornes électriques de la microbatterie, en contact avec l'anode et la cathode.

La cathode 18, l'électrolyte 20 et l'anode 22 sont ensuite déposés successivement sur le substrat 4 et les collecteurs de courant métalliques 16a et 16b.

La cathode 18, en TIOS, V₂O₅ ou TiS₂, est déposée sur une partie du collecteur cathodique 16a, par exemple par évaporation sous vide ou par pulvérisation cathodique. La couche d'électrolyte 20 en LiPON est déposée sur la cathode 18, ainsi que sur une partie du collecteur anodique 16b et sur la zone du substrat 4 séparant les collecteurs 16a et 16b. Le dépôt de l'électrolyte 20 est, par exemple, réalisé par pulvérisation cathodique de manière à obtenir une couche en LiPON exempte de défauts. Enfin, l'anode 22 est déposée sur la couche d'électrolyte 20 et le collecteur de courant anodique 16b. De préférence, l'anode 22 est formée de lithium métallique et déposée par évaporation sous vide.

A l'étape de la figure 6, une structure tampon 14 comprenant au moins une couche en alumine, ou en oxyde d'aluminium, est déposée sur l'empilement 2 de couches actives, et notamment les surfaces libres de l'électrolyte 20 et l'anode 22.

Dans un mode de mise en oeuvre préférentiel, la couche d'alumine est obtenue par dépôt de couches atomiques (ALD, « Atomic Layer Deposition » en anglais). Le dépôt de l'alumine par ALD procure de nombreux avantages en comparaison des autres techniques de dépôt de couches minces, type CVD (« Chemical Vapor Deposition ») ou PVD (« Physical Vapor Deposition »). Cette technique permet notamment d'obtenir un dépôt conforme, c'est-à-dire d'une épaisseur sensiblement constante (variation de l'épaisseur de moins de 1 %). Les couches actives au lithium sont alors couvertes de façon homogène. Par ailleurs, une couche en alumine déposée par ALD est dense, ce qui favorise le blocage des ions lithium.

Comme représenté sur la figure 6, la couche d'alumine déposée par ALD recouvre la totalité du substrat 4 et de l'empilement 2, à savoir les collecteurs 16a, 16b, l'électrolyte 20 et l'anode 22.

Le mode opératoire décrit ci-dessous a permis d'obtenir une structure tampon 14 comprenant au moins une couche d'alumine disposant d'excellentes propriétés barrière, tant pour le blocage du lithium que pour le blocage de ses espèces oxydantes.

Dans ce mode de mise en oeuvre, le dépôt ALD est réalisé à partir d'un premier précurseur organométallique contenant de l'aluminium, tel que le triméthyl-aluminium (TMA), et d'un deuxième précurseur contenant de l'eau, par exemple de l'eau dé-ionisée. La température du dépôt est, de préférence, choisie entre 80 °C et 150 °C, soit une température bien inférieure à la température de fusion du lithium (environ 180 °C).

On sait que la réaction de l'eau avec le lithium des couches actives est néfaste pour le fonctionnement de la microbatterie, c'est pourquoi on souhaite la protéger avec un dispositif d'encapsulation. L'eau est un oxydant majeur du lithium et, par conséquent, son utilisation comme précurseur dans le procédé ALD paraît inopportun. Pourtant, on constate de façon surprenante que le précurseur à base d'eau ne provoque aucune oxydation des couches actives pendant le dépôt ALD. Les microbatteries au lithium fabriquées selon ce mode opératoire ne présentent aucun dommage et sont électriquement fonctionnelles.

Les deux précurseurs sont avantageusement introduits de manière séquentielle et cyclique, en commençant par le TMA. D'une part, cela permet aux molécules de chaque précurseur d'occuper les sites vacants pour former une couche atomique, avant l'introduction du précurseur suivant. D'autre part, cela laisse la possibilité de faire évacuer les molécules qui n'ont pas réagi, ainsi que les produits de réaction. Ainsi, chaque période d'introduction d'un précurseur est avantageusement suivie d'une période de purge, avant d'introduire le précurseur suivant. En d'autres termes, le dépôt ALD est réalisé par une succession de cycles, dont le nombre dépend de l'épaisseur de la couche d'alumine. Chaque cycle comprend :
- une période d'introduction du TMA, par exemple de 40 secondes ;
- une période de purge, par exemple de 40 secondes également ;
- une période d'introduction de l'eau dé-ionisée (ex. 40 s) ; et
- une période de purge (ex. 40 s).

L'épaisseur de la couche d'alumine peut être contrôlée en ajustant le nombre de cycles. L'épaisseur optimale de la couche d'alumine est d'environ 50 nm, ce qui correspond par exemple à environ 500 cycles de 4 fois 40 s. La température optimale du dépôt est de l'ordre 80 °C. La couche d'alumine obtenue dans ces conditions préférentielles présente les meilleures performances barrière et les couches actives au lithium sous-jacentes ne sont pas impactées.

Après que la structure tampon 14 comprenant au moins une couche d'alumine a été formée (Fig.6), une couche en matériau polymérisable 10' est disposée entre la structure tampon 14 et le capot de protection 8. La couche de matériau polymérisable 10' est configurée pour former une couche de colle.

La couche en matériau polymérisable 10' peut être déposée sur la structure tampon 14 préalablement au report du capot de protection 8. Cette étape est représentée à la figure 7.

Selon un autre mode de réalisation, la couche de matériau polymérisable 10' est déposée sur le capot de protection 8 préalablement au report du capot de protection 8 avec la couche polymérisable 10' sur la structure tampon 14.

La couche de colle 10' est, avantageusement, déposée sur la structure tampon 14. Elle est, de préférence, déposée pleine plaque, c'est-à-dire sur toute la surface de l'empilement 2 et du substrat 4. A la différence de la couche d'alumine 14, l'épaisseur de la couche 10' n'est pas constante. En effet, la couche 10' compense les variations de hauteur dues à l'empilement 2, de sorte à obtenir une face supérieure sensiblement plane, idéale pour le report ultérieur du capot.

La colle utilisée pour fixer le capot sur l'empilement est formée d'un matériau polymérisable. Par matériau polymérisable, on entend une solution comprenant des monomères (ou prépolymères) et au moins un amorceur de polymérisation, de préférence de type cationique. Les monomères à base d'éthers vinyliques ou les monomères hétérocycliques (époxydes, lactones, éthers cycliques, époxysilicones...) peuvent être utilisés. Les monomères époxydes et éthers vinyliques étant particulièrement réactifs, ils seront privilégiés de manière à obtenir une polymérisation rapide.

Certains produits du commerce, appelés communément résines photo-polymérisables ou thermodurcissables, comprennent ces monomères, notamment ceux commercialisés par la société Epoxy Technology sous la dénomination « OG » (OG146-178, UVO-114, OG115, OG114-4, OG146) et sous la dénomination « Epo-Tek » (Epo-Tek-330, Epo-Tek-360). Les produits de la série « OG » sont réticulés par rayons UV tandis que les produits de la série « Epo-Tek » sont réticulés par voie thermique.

Avantageusement, le matériau polymérisable a une viscosité inférieure à 1000 cPs (centipoise). Ainsi, la couche 10' épouse parfaitement les formes de l'empilement 2.

La couche de matériau polymérisable 10' est, de préférence, déposée sur l'ensemble d'un substrat par dépôt à la tournette. Cette technique est facile à mettre en oeuvre, bien adaptée aux matériaux polymères et permet en outre de contrôler simplement l'épaisseur de couche polymère.

L'épaisseur de la couche 10' est, de préférence, comprise entre 2 µm et 20 µm en fonction de la vitesse et la durée de rotation de la tournette. A titre d'exemple, une couche 10' de résine OG146-178, de 10 µm d'épaisseur, est obtenue par dépôt à la tournette, à une vitesse de 1200 trs/min pendant 40 s.

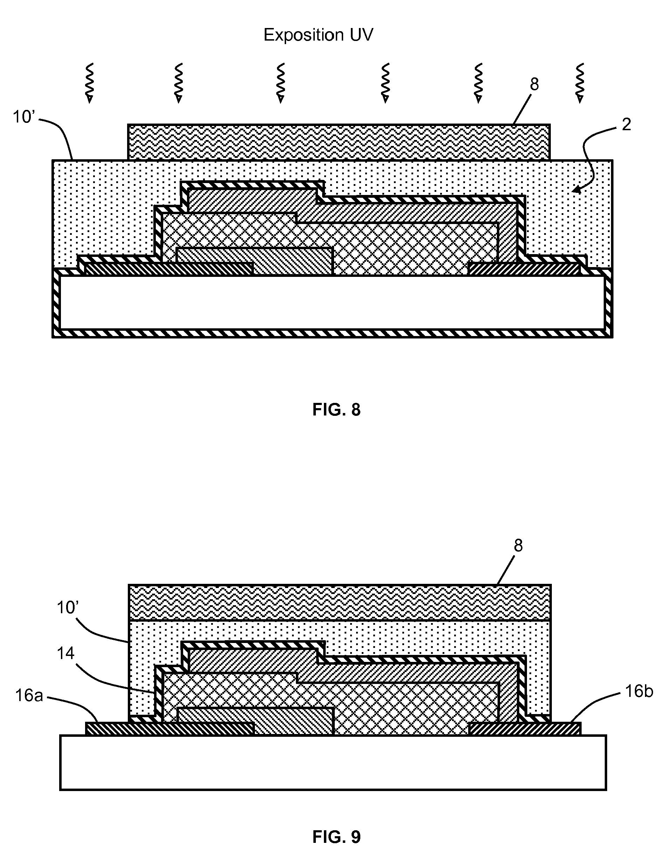

A la figure 8, le capot 8 est positionné sur la couche 10' en matériau polymérisable, en regard de l'empilement 2 de couches actives. De préférence, le capot 8 repose entièrement sur la couche 10'. Puis, le matériau polymérisable 10' est réticulé, thermiquement ou par rayons ultraviolets (300-500 nm) dans le cas d'un capot transparent, en verre par exemple. L'exposition aux rayons UV ou le traitement thermique permet le durcissement de la résine et la fixation du capot 8 sur l'empilement 2.

De préférence, la réticulation des polymères thermosensibles s'effectue à une température comprise entre 80 °C et 150 °C pour éviter de dégrader les couches de lithium et la réticulation des polymères photosensibles s'opère par une exposition aux ultraviolets avec une densité de puissance de 100 mW/cm² pendant une durée inférieure à 10 mn. Par exemple, sur la figure 8, la couche de résine OG146-178 de 10 µm d'épaisseur est durcie après 5 min d'exposition UV à travers le capot 8.

La réticulation/polymérisation de la couche polymère permet de coller le capot de protection 8 à l'empilement 2 de couches actives via la structure tampon 14.

Enfin, l'étape de la figure 9 consiste à graver successivement la couche de polymère durci 10' et la couche d'alumine 14 sur les bords de la microbatterie, afin de libérer une partie des collecteurs 16a et 16b.

La couche 10' est avantageusement gravée de façon anisotrope et sélective, en utilisant le capot 8 comme masque de gravure. Cette gravure est, de préférence, mise en oeuvre par un plasma d'oxygène O₂ ou d'un mélange gazeux d'oxygène (O₂) et gaz fluoré (SF₆). Dans le cas de la résine OG146-178 de 10 µm d'épaisseur, la couche 10' est par exemple gravée jusqu'à la couche d'alumine 14 après application d'un plasma O₂ (90 sccm)/SF₆ (10 sccm) à une puissance de 100 W pendant 10 mn.

La couche en alumine peut être réalisée par voie sèche ou humide. Les solutions de gravure humide sont typiquement à base d'acide fluorhydrique (HF). Un mélange d'acide nitrique, d'acide phosphorique et d'acide acétique (HNO₃/H₃PO₄/CH₃COOH) peut également être employé. La gravure d'une couche en alumine de 50 nm d'épaisseur est, par exemple, réalisée en plongeant le substrat dans un bain d'HF pendant 2 min ou dans un mélange de HNO₃ (1-5%)/H₃PO₄ (65-75%)/CH₃COOH (5-10%) dilué dans l'eau pendant 12 min. Les solutions de gravure sèche consistent en un plasma chloré, par exemple BCl₂, CCl₄, CHCl₃ ou SiCl₄.

De nombreuses variantes et modifications de la microbatterie au lithium et de son procédé de fabrication apparaitront à l'homme du métier. En particulier, le collage du capot 8 pourra être réalisé au niveau des faces latérales de l'empilement 2, plutôt qu'en face supérieure. Un cordon de colle de moins de 100 µm de hauteur peut être formé autour du composant, par exemple au moyen d'une seringue à débit et ouverture commandés. A la différence de l'art antérieur, le cordon de colle sera disposé en contact avec l'empilement de couches actives, en ayant au préalable recouvert les flancs de l'empilement par la couche d'alumine.

Cet agencement permet de réduire l'épaisseur de la microbatterie de quelques micromètres, pour certaines applications dans lesquelles les contraintes d'intégration sont fortes. L'encapsulation de la microbatterie est, pour autant, optimisée car le capot et la couche d'alumine assurent respectivement la protection surfacique et la protection des flancs de la microbatterie.

## Revendications

1. Microbatterie au lithium comprenant un empilement (2) de couches actives (18, 20, 22) contenant du lithium et un capot de protection (8) couvrant l'empilement (2) de couches actives (18, 20, 22), **caractérisée en ce que** le capot de protection est fixé à l'empilement (2) de couches actives (18, 20, 22) au moyen d'une couche de colle (10') et **en ce qu'**elle comporte une structure tampon (14) comportant au moins une couche en alumine disposée entre l'empilement (2) de couches actives et la couche de colle (10'), la structure tampon étant en contact avec ledit empilement (2) de couches actives (18, 20, 22).

2. Microbatterie selon la revendication 1, dans laquelle la couche d'alumine de la structure tampon (14) est en contact avec la couche de colle (10').

3. Microbatterie selon l'une des revendications 1 et 2, dans laquelle au moins la couche en alumine de la structure tampon (14) couvre entièrement l'empilement de couches actives (18, 20, 22).

4. Microbatterie selon l'une quelconque des revendications 1 à 3, dans laquelle l'empilement (2) de couches actives (18, 20, 22) comporte une électrode (22) en lithium métallique en contact avec la structure tampon (14).

5. Microbatterie selon l'une quelconque des revendications 1 à 4, dans laquelle la couche en alumine a une épaisseur comprise entre 5 nm et 50 nm.

6. Procédé de fabrication d'une microbatterie au lithium, comprenant les étapes suivantes :
- prévoir un empilement (2) de couches actives (18, 20, 22) contenant du lithium ;
- déposer une structure tampon (14) comportant au moins une couche en alumine sur l'empilement (2) de couches actives (18, 20, 22) ;
- couvrir l'empilement (2) de couches actives (18, 20, 22) et la structure tampon (14) par un capot de protection (8), une couche en matériau polymérisable (10') étant disposée entre la structure tampon (14) et le capot de protection (8) ; et
- réticuler le matériau polymérisable pour coller le capot (8) à l'empilement (2) de couches actives (18, 20, 22) via la structure tampon (14).

7. Procédé selon la revendication 6, dans lequel la couche en matériau polymérisable est déposée soit sur la structure tampon (14) préalablement au report du capot de protection (8), soit sur le capot de protection (8) préalablement au report du capot de protection (8) avec la couche polymérisable (10') sur la structure tampon (14).

8. Procédé selon l'une des revendications 6 et 7, dans lequel la couche d'alumine est obtenue par dépôt de couches atomiques.

9. Procédé selon la revendication 8, dans lequel le dépôt de couches atomiques est réalisé à partir d'un premier précurseur contenant de l'aluminium et d'un deuxième précurseur contenant de l'eau.

10. Procédé selon la revendication 9, dans lequel les premier et deuxième précurseurs sont utilisés de façon successive, en commençant par le premier précurseur.

11. Procédé selon l'une quelconque des revendications 6 à 10, dans lequel le dépôt de couches atomiques est réalisé à une température comprise entre 80 °C et 150 °C.

## Patentansprüche

1. Lithium-Mikrobatterie, die eine Stapelung (2) von aktiven Schichten (18, 20, 22), welche Lithium enthalten, sowie eine Schutzhülle (8), die die Stapelung (2) aktiver Schichten (18, 20, 22) abdeckt, aufweist,
**dadurch gekennzeichnet,**
**dass** die Schutzhülle an der Stapelung (2) aktiver Schichten (18, 20, 22) vermittels einer Klebschicht (10') befestigt ist und dass die Batterie eine Sperrstruktur (14) mit mindestens einer Aluminiumschicht aufweist, die zwischen der Stapelung (2) aktiver Schichten und der Klebschicht (10') angeordnet ist, wobei die Sperrstruktur sich in Kontakt mit der Stapelung (2) aktiver Schichten (18, 20, 22) befindet.

2. Mikrobatterie nach Anspruch 1, bei der die Aluminiumschicht der Sperrstruktur (14) sich in Kontakt mit der Klebschicht (10') befindet.

3. Mikrobatterie nach einem der Ansprüche 1 und 2, bei der zumindest die Aluminiumschicht der Sperrstruktur (14) die Stapelung (2) aktiver Schichten (18, 20, 22) vollständig abdeckt.

4. Mikrobatterie nach einem der Ansprüche 1 bis 3, bei der die Stapelung (2) aktiver Schichten (18, 20, 22) eine metallene Lithium-Elektrode (22) enthält, die sich in Kontakt mit der Sperrstruktur (14) befindet.

5. Mikrobatterie nach einem der Ansprüche 1 bis 4, bei der die Aluminiumschicht eine Dicke von 5 nm bis 50 nm aufweist.

6. Verfahren zur Herstellung einer Lithium-Mikrobatterie, das die folgenden Verfahrensschritte umfasst:
- Anfertigen einer Stapelung (2) aktiver Schichten (18, 20, 22), welche Lithium enthalten,
- Aufbringen einer Sperrstruktur (14), die mindestens eine Aluminiumschicht umfasst, auf die Stapelung (2) aktiver Schichten (18, 20, 22),
- Abdecken der Stapelung (2) aktiver Schichten (18, 20, 22) und der Sperrstruktur (14) durch eine Schutzhülle (8), wobei eine Schicht aus polymerisierbarem Material (10') zwischen der Sperrstruktur (14) und der Schutzhülle (8) angeordnet wird, und
- Vernetzen des polymerisierbaren Materials, um die Schutzhülle (8) über die Sperrstruktur (14) an der Stapelung (2) aktiver Schichten (18, 20, 22) anzukleben.

7. Verfahren nach Anspruch 6, bei dem die Schicht aus polymerisierbarem Material entweder auf der Sperrstruktur (14) aufgebracht wird, bevor die Schutzhülle (8) angebracht wird, oder auf der Schutzhülle (8) aufgebracht wird, bevor die Schutzhülle (8) mit der Schicht aus polymerisierbarem Material (10') auf der Sperrstruktur (14) angebracht wird.

8. Verfahren nach einem der Ansprüche 6 und 7, bei dem die Aluminiumschicht durch Aufbringen von Atomschichten hergestellt wird.

9. Verfahren nach Anspruch 8, bei dem das Aufbringen von Atomschichten mit einem ersten Zwischenstoff, der Aluminium enthält, und einem zweiten Zwischenstoff, der Wasser enthält, erfolgt.

10. Verfahren nach Anspruch 9, bei dem der erste und der zweite Zwischenstoff nacheinander verwendet werden, wobei mit dem ersten Zwischenstoff begonnen wird.

11. Verfahren nach einem der Ansprüche 6 bis 10, bei dem das Aufbringen von Atomschichten bei einer Temperatur von 80 °C bis 150 °C erfolgt.

## Claims

1. A lithium microbattery comprising a stack (2) of active layers (18, 20, 22) containing lithium and a protective cover (8) covering the stack (2) of active layers (18, 20, 22), **characterized in that** the protective cover is fixed to the stack (2) of active layers (18, 20, 22) by a layer of glue (10') and **in that** it comprises a buffer structure (14) comprising at least one alumina layer arranged between the stack (2) of active layers and the layer of glue (10'), the buffer structure being in contact with said stack (2) of active layers (18, 20, 22).

2. The microbattery according to claim 1, **characterized in that** the alumina layer of the buffer structure (14) is in contact with the layer of glue (10').

3. The microbattery according to claim 1 and 2, **characterized in that** at least the alumina layer of the buffer structure (14) completely covers the stack of active layers (18, 20, 22).

4. The microbattery according to any of claims 1 to 3, **characterized in that** the stack (2) of active layers (18, 20, 22) comprises a metallic lithium electrode (22) in contact with the buffer structure (14).

5. The microbattery according to any of claims 1 to 4, **characterized in that** the alumina layer has a thickness comprised between 5 nm and 50 nm.

6. A fabrication method of a lithium microbattery, comprising the following steps:
- providing a stack (2) of active layers (18, 20, 22) containing lithium;
- depositing a buffer structure (14) comprising at least one alumina layer on the stack (2) of active layers (18, 20, 22);
- covering the stack (2) of active layers (18, 20, 22) and the buffer structure (14) by a protective cover (8), a layer of polymerizable material (10') being disposed between the buffer structure (14) and the protective cover (8); and
- cross-linking the polymerizable material to stick the protective cover (8) to the stack (2) of active layers (18, 20, 22) via the buffer structure (14).

7. The method according to claim 6, **characterized in that** the layer of polymerizable material is deposited either on the buffer structure (14) prior to fitting of the protective cover (8) or on the protective cover (8) prior to fixing of the protective cover (8) with the layer of polymerizable material (10') on the buffer structure (14).

8. The method according to any of claims 6 and 7, **characterized in that** the alumina layer is obtained by atomic layer deposition.

9. The method according to claim 8, **characterized in that** the atomic layer deposition is performed from a first precursor containing aluminium and a second precursor containing water.

10. The method according to claim 9, **characterized in that** the first and second precursors are used in successive manner starting with the first precursor.

11. The method according to any of claims 6 to 10, **characterized in that** atomic layer deposition is performed at a temperature comprised between 80 °C and 150 °C.
